# EUROPEAN PATENT APPLICATION

(11) **EP 4 528 811 A1**
(43) Date of publication of application: **26.03.2025**
(21) Application number: 24194545.0
(22) Date of filing: 14.08.2024
(51) Int. Cl.: H01L 23/495, H01L 21/683, H01L 23/00

(54) **PACKAGED SEMICONDUCTOR DEVICE AND METHOD OF MANUFACTURING**

(30) Priority: 18.08.2023 CN 202311047233
(71) Applicant: NXP USA, Inc., Austin TX 78735 (US)
(72) Inventor: GE, You, 5656AG Eindhoven (NL); TZOU, Kuei-Kang, 5656AG Eindhoven (NL); LEE, Chu-Chung, 5656AG Eindhoven (NL); TRACHT, Neil Thomas, 5656AG Eindhoven (NL); WANG, Zhijie, 5656AG Eindhoven (NL); LEE, Yit Meng, 5656AG Eindhoven (NL)
(74) Representative: Hardingham, Christopher Mark

(57) **Abstract**

A packaged semiconductor device has a top surface and a bottom surface opposite the top surface. The packaged semiconductor device includes a device die, a plurality of perimeter landings, connection lines, and molding compound. The device die has a first surface and a second surface opposite the first surface. The device die is arranged in a central region of the packaged semiconductor device. The first surface of the device die is arranged towards the bottom surface of the packaged semiconductor device, and the second surface of the device die is arranged towards the top surface of the packaged semiconductor device. The plurality of perimeter landings are exposed on the bottom surface of the packaged semiconductor device and are arranged at perimeter regions of the bottom surface surrounding the device die. The connection lines are connected to the second surface of the device die. Each connection line provides electrical connection between a corresponding connection pad on the second surface of the device die and a corresponding one of the plurality of perimeter landings. The molding compound at least partially encapsulates the device die and the plurality of perimeter landings. The plurality of perimeter landings are made of a material having a mass fraction of tin of at least 95%.

## Description

### BACKGROUND

The present disclosure relates to a packaged semiconductor device and a method of manufacturing the packaged semiconductor device.

Leadless packaged semiconductor devices, such as quad flat no lead ("QFN") packaged devices, have compact sizes because the perimeter landings on the bottom surface are defined within the outline of the package. A QFN packaged device is manufactured by placing and connecting a chip die to a lead-frame, and molding the connected assembly. QFN and similar packaged devices have requirements of becoming more compact.

### SUMMARY

This summary is provided to introduce a selection of concepts in a simplified form that are further described below in the Detailed Description. This summary is not intended to identify key or essential features of the claimed subject matter, nor is it intended to be used to limit the scope of the claimed subject matter.

In one embodiment, a packaged semiconductor device has a top surface and a bottom surface opposite the top surface. The packaged semiconductor device includes a device die, a plurality of perimeter landings, connection lines, and molding compound. The device die has a first surface and a second surface opposite the first surface. The device die is arranged in a central region of the packaged semiconductor device. The first surface of the device die is arranged towards the bottom surface of the packaged semiconductor device, and the second surface of the device die is arranged towards the top surface of the packaged semiconductor device. The plurality of perimeter landings are exposed on the bottom surface of the packaged semiconductor device and are arranged at perimeter regions of the bottom surface surrounding the device die. The connection lines are connected to the second surface of the device die. Each connection line provides electrical connection between a corresponding connection pad on the second surface of the device die and a corresponding one of the plurality of perimeter landings. The molding compound at least partially encapsulates the device die and the plurality of perimeter landings. The plurality of perimeter landings are made of a material having a mass fraction of tin of at least 95%.

In an embodiment, a method of manufacturing a packaged semiconductor device includes: providing a patterned paste material having a mass fraction of tin of at least 95% on a carrier; reflowing the patterned paste material to form a plurality of arranged perimeter landings; positioning a device die on the carrier such that it is surrounded by the plurality of arranged perimeter landings; filling molding compound to integrate the perimeter landings and the device die into an integral assembly having a first surface; and forming a connection line, between a connection pad on a first surface of the device die on the first surface of the integral assembly, and a one of the plurality of arranged perimeter landings, to provide electrical connection therebetween.

In one or more embodiments, the placing the device die on the first side of the tape comprises facing a first side surface of the device die towards the tape. In one or more embodiments, the method further comprises coating the first surface the integral assembly with a coating layer, the coating layer covering the connection line. In one or more embodiments, the coating the first surface of the integral assembly comprises applying the coating layer to a thickness which is equal to or larger than a thickness of the connection line.

In one or more embodiments, the thickness of the connection line is in a range of 10µm and 20µm. In one or more embodiments the filling molding compound to integrate the perimeter landings and the device die into the integral assembly comprises: placing the perimeter landings and the device die into a molding cavity; and filling molding compound into the molding cavity to integrate the perimeter landings and the device die into the integral assembly.

### BRIEF DESCRIPTION OF THE DRAWINGS

So that the manner in which the above recited features of the present disclosure can be understood in detail, a more detailed description of the disclosure may be had by reference to embodiments, some of which are illustrated in the appended drawings. The appended drawings illustrate only typical embodiments of the disclosure and should not limit the scope of the disclosure, as the disclosure may have other equally effective embodiments. The drawings are for facilitating an understanding of the disclosure and thus are not necessarily drawn to scale. Advantages of the subject matter claimed will become apparent to those skilled in the art upon reading this description in conjunction with the accompanying drawings, in which like reference numerals have been used to designate like elements, and in which:
FIG. 1 is a cross-sectional view of a packaged semiconductor device of an embodiment;
FIG. 2 is a flow diagram of manufacturing a packaged semiconductor device of an embodiment; and
FIG. 3 to FIG. 14 are diagrams of products during manufacturing of the packaged semiconductor device according to the method of FIG. 2; and
FIG. 15 is a partial plan view of a products after placing a device die according to another embodiment.

### DETAILED DESCRIPTION

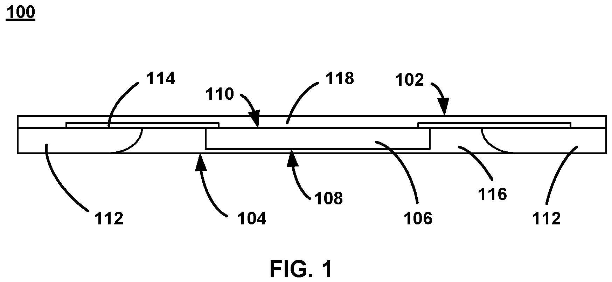

FIG. 1 is a cross-sectional view of a packaged semiconductor device according to an embodiment. The packaged semiconductor device 100 has a top surface 102 and a bottom surface 104 opposite the top surface 102. The packaged semiconductor device 100 includes a device die 106 located in a central area of the semiconductor device 100. The device die 106 has a first surface 108 and a second surface 110 which is opposite the first surface 108. As can be seen from FIG. 1, the first surface 108 of the device die 106 is arranged towards the bottom surface 104, while the second surface 110 is arranged towards the top surface 102.

The packaged semiconductor device 100 further includes multiple perimeter landings 112 that are arranged around a perimeter of the bottom surface 104 and surrounding the device die 106. Typically, the thickness of the device die 106, measuring from the first surface 108 to the second surface 110, is in a range of 5 mil (0.125mm) and 15 mil (0.375mm). The thickness of each perimeter landing 112 can be equal to, larger than or less than the thickness of the device die 106, and is typically 80% to 100% of the thickness of the device die 106, and is further typically around 5 mil, which is about 0.125mm. The perimeter landings 112 are connected to the device die 106 through a corresponding connection line 114. Specifically, the connection lines 114 are attached to the second surface 110 of the device die 106. Each of the connection lines 114 connects a corresponding connection pad (not shown) on the second surface 110 of the device die 106 to a corresponding one of the multiple perimeter landings 112. The device die 106 is placed in the semiconductor device 100 such that an active area of the device die 106 faces towards the second surface 110, to provide connections to the connection lines 114 on the second surface 110. In various embodiments, the connection lines 114 can be implemented as materials of copper clips that have a flat shape, etc., and have a thickness in a range of 10µm and 20µm.

The packaged semiconductor device 100 further includes molding compound 116 that at least partially encapsulates the device die 106 and the perimeter landings 112. The molding compound 116 is electrically insulating. The molding compound 116 fills in gaps between the device die 106 and the perimeter landings 112, to a thickness equal to or larger than the thickness of the device die 106, such that the molding compound 116 is exposed on, and forms part of, the bottom surface 104 of the packaged semiconductor device 100. The second surface 110 of the device die 106 is coplanar with the surface of the molding compound 116, to allow the connection lines 114 to contact the second surface 110, which means the connection lines 114 are arranged over the molding compound 116.

According to the embodiment, the perimeter landings 112 are made of a material having a mass fraction of tin of at least 95%. Specifically, the perimeter landings 112 are formed by printing a paste material through apertures of a stencil, and reflowing the printed paste material. The paste material includes tin with a high mass fraction, and has an eutectic temperature of at least 210 degree Celsius (210°C). For example, some Pb-free high-Sn paste materials have even high eutectic temperatures as high as 280°C. Material for the perimeter landings 112 are selected such that the eutectic temperature of the perimeter landings 112 is high enough, and will not melt when the final packaged semiconductor device 100 is mounted to a Printed Circuit Board (PCB) by Surface Mounting Technologies (SMT) in which solder paste is used for mounting the packaged semiconductor device onto the PCB and then reflowed. Solder pastes have lower eutectic temperatures than that of high-Sn pastes.

Also in view of the material for the perimeter landings 112, the molding compound 116 of the semiconductor device 100 has a melting temperature which is lower than the eutectic temperature of the perimeter landings 112. Conveniently, the molding compound 116 of the semiconductor device 100 is selected from Epoxy Molding Compound (EMC) materials with melting temperatures around 175°C.

The packaged semiconductor device 100 can include a coating layer 118 which is disposed over the top surface 102. The coating layer 118 protects the second surface 110 of the device die 106 that is exposed from the molding compound 116, the connection lines 114, and the exposing part of the perimeter landings 112, from corrosion due to oxidation, humidity, etc. A thickness of the coating layer 118 is at least equal to the thickness of the connection lines 114, and preferably in a range of 25µm and 40µm. The coating layer 118 can be disposed over the top surface 102 by spray painting or lacquering conformal coatings, which when cured isolates and protects the covered units.

The packaged semiconductor device 100 includes the perimeter landings 112 that are formed by Sn pastes for providing external connections to the device die 106, instead of convention lead-frames. Because the connection lines 114 are arranged immediately adjacent the surface of the die (rather than requiring a flexure loop as is the case with convention wire bonding), the packaged semiconductor device 100 can be manufactured such that its thickness can be as compact as 0.05mm to 0.1mm.

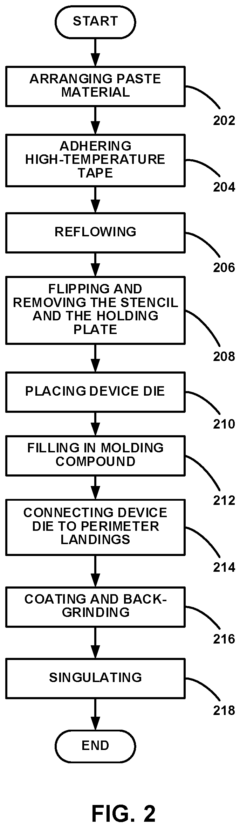

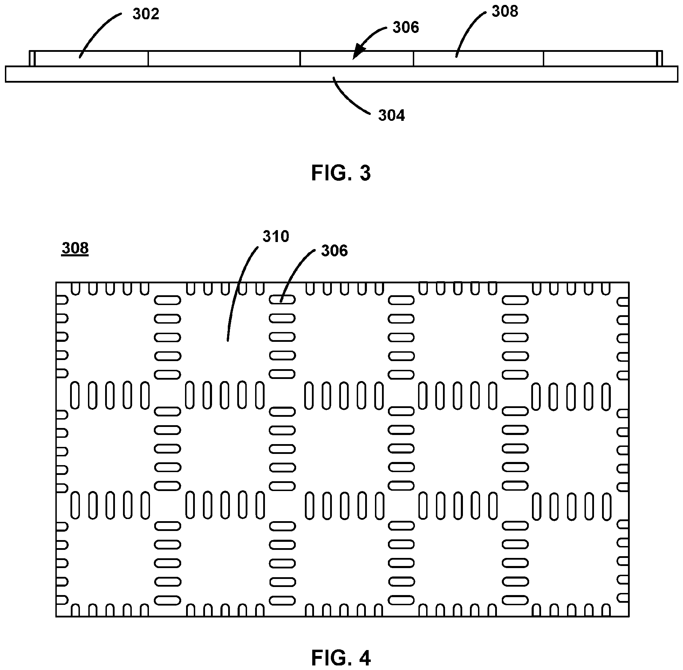

FIG. 2 is a flow diagram of a method of manufacturing a packaged semiconductor device. The method can be implemented to manufacture the packaged semiconductor device 100 of FIG. 1. The method will be described basing on FIG. 2 and also with references to FIGs. 3 to 14 that show cross-sectional views of parts manufactured through the steps of FIG. 2.

Step 202 of the method includes arranging paste material. Referring to FIG. 3, paste material 302 is disposed onto a holding plate, or a carrier, 304. The holding plate 304 is typically a non-wetting plate, for example, a ceramic plate, or otherwise includes a release layer at its surface. The paste material 302 is arranged on the holding plate 304 as a patterned paste material. In some embodiments, the paste material 302 is printed through apertures 306 of a stencil 308 which has been non-wetting treated. Known screen printing techniques may be used to dispose the paste material 302. The paste material 302 may be printed to a thickness equal to, or similar to, that of the stencil 308. Typically, the stencil 308 has a thickness of 5 mil, which is about 0.125mm. In some embodiments, the stencil 308 has the thickness equal to a thickness of a device die to be placed for manufacturing the packaged semiconductor device. The paste material 302 in this embodiment includes tin which has a mass fraction of at least 95%, as has been described above, to have a relatively high eutectic temperature.

FIG. 4 depicts a partial and plan view of the stencil 308. The stencil 308 has the apertures 306 that are aligned respectively along intersecting directions. An area 310 surrounded by the apertures 306 allows no paste material to be printed after the stencil 308 is placed on the holding plate 304, and subsequently the area 310 will be placed with a device die. The illustrated stencil 308 is an array of units each includes a corresponding area 310 and the surrounding apertures 306. As will be described below, each unit of the array will form a corresponding packaged semiconductor device. See from FIG. 4 that a piece of paste material 302 will be printed conformal the aperture 306. The piece of paste material, after reflowing as described below and finally solidified, forms a region which will eventually become two perimeter landings (one for each of two die). The region will also include a sacrificial region that will be lost due to the width of the subsequent sawblade and kerf-loss, as will be further described below in more details.

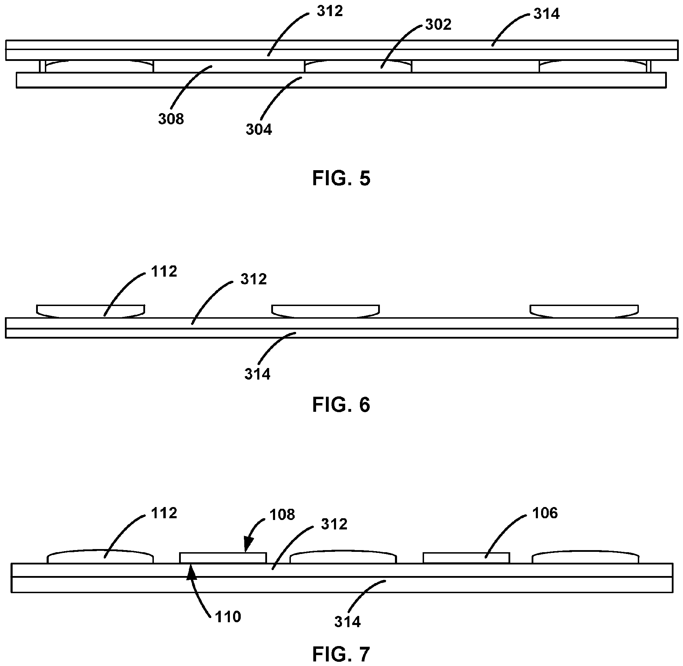

In step 204 of the method of FIG. 2, a high-temperature tape is applied onto the stencil 308, covering the stencil 308 and the printed paste material 302. FIG. 5 is a cross-sectional view of the holding plate 304, the stencil 308, and the covering tape. The high-temperature tape 312 is adhered to the stencil 308 and the paste material 302, typically with another clamping plate 314 on the other side of the high-temperature tape 312 for applying a force to push the high-temperature tape 312 towards the stencil 308 and the paste material 302, thereby ensuring the high-temperature tape 312 reliably adheres to the paste material 302.

Step 206 follows the step 204 of the method, to reflow the printed paste material 302. With reference also to FIG. 5, the assembly is heated to at least the eutectic temperature of the paste material 302. Specifically, the holding plate 304 is heated, and accordingly heats up the paste material 302 on the holding plate 304 and in the apertures 306. As described, the paste material 302 has an eutectic temperature of at least 210°C, the reflowing step 206 heats up the paste material 302 until it is in a molten state and solvents in the paste material 302, which are relative volatile, evaporate. Subsequently, it is cooled down, melted metal elements in the paste material solidifies, and forms perimeter landings for the semiconductor device to be manufactured. It can be understood that the resulting perimeter landings are now sandwiched by the holding plate 304 and the high-temperature tape 312, and comprise mainly tin, or a high-tin fraction alloy of tin.

Referring to FIG. 2, and FIG. 6, the method further includes step 208, to flip the product from the previous step 206, so that the clamping plate 314, also referred to as a supporting plate, is on the bottom and supports the high-temperature tape 312, the perimeter landings 112 (similarly labelled as that in FIG. 1), the stencil 308, and the holding plate 304. For supporting and holding the high-temperature tape 312, the perimeter landings 112, the stencil 308, and the holding plate 304, the supporting plate 314 is selected to be rigid enough. Due to the flipping, the stencil 308 and the holding plate 304 are on the top, and are easy to be removed. Because the stencil 308 is non-wetting treated and the high-temperature tape 312 is adhesive, the perimeter landings 112 remain on the high-temperature tape 312.

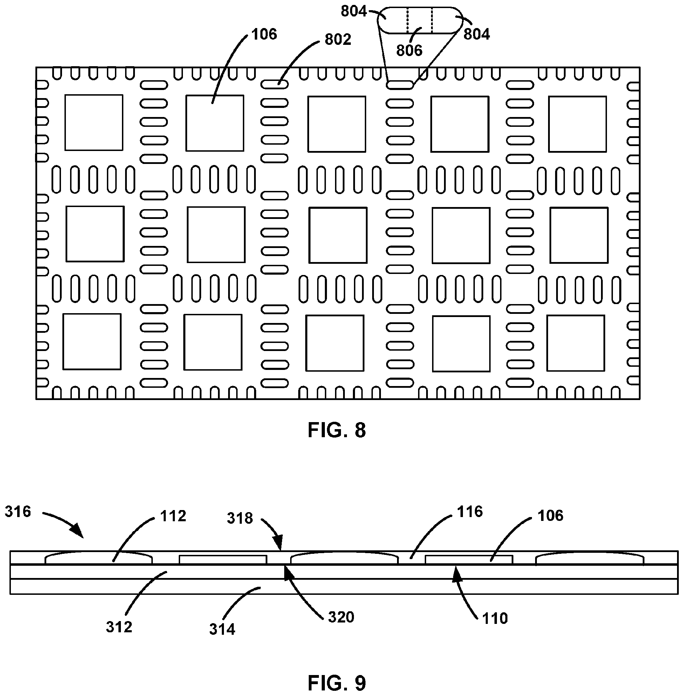

In step 210 of the method, a device die is placed onto the high-temperature tape, and is placed to be surrounded by the perimeter landings. Referring to FIG. 7 which is a cross-sectional view of the product after step 210, and FIG. 8 which is a plan view of the product after the device die is placed, as described above with reference to FIG. 4, the device die 106 is placed in the central area 310, and surrounded by the plurality of arranged regions 802. It now can be understood that both the regions 802 and the device die 106 are arranged on a first side of the high-temperature tape 312, while the supporting plate 314 is on a second, opposite side of the high-temperature tape 312. The device die 106 has the first surface 108 which is away from the tape 312, and the second surface 110 which faces toward and contacts the tape 312 when the device die 106 is placed on the tape 312. Also as described above, the active area, or active layers, of the device die 106 faces towards the second surface 110. The region 802 is substantially oval, two ends 804 of the region 802 will become the perimeter landings respectively used for providing external connections for neighboring device die 106. A sacrificial region 806 between the ends 804 will be removed during subsequent saw blading and/or etching, shown as dotted line in FIG. 8.

Referring back to FIG. 2, the method further includes step 212, filling molding compound into gaps between the device die 106 and the perimeter landings 112, to integrate the perimeter landings and the device die together. Referring also to FIG. 9, the perimeter landings 112 and the device die 106 are placed into a molding cavity (not shown), and the molding compound 116 is filled, or injected, into the molding cavity to integrate the perimeter landings 112 and the device die 106 into an integral assembly 316 which includes the perimeter landings 112, the device die 106, and the filled molding compound 116. The integral assembly 316 has a first, top, surface 318 and a second, bottom, surface 320. The second surface 320 contacts the high-temperature tape 312. As explained above, in view of the paste material for the perimeter landings 112, the molding compound 116 should be selected to have a melting temperature which is lower than the eutectic temperature of the perimeter landings 112. Typically, the molding compound 116 is selected from Epoxy Molding Compound (EMC) materials with melting temperatures around 175°C.

After the molding compound 116 cures and the integral assembly 316 is ejected from the molding cavity, the high-temperature tape 312 and the supporting plate 314 is removed. After the removal of the high-temperature tape 312 and the supporting plate 314, the second surface 110 of the device die 106, which is the surface near the active region of the device die 106, is exposed. The thickness of the applied molding compound 116, measuring from the first surface 318 to the second surface 320, is equal to or higher than a larger one of the thicknesses of the perimeter landings 112 and the device die 106, such that the molding compound 116 is thick enough to protect the device die 106 and the perimeter landings 112. Which means, after the removal of the tape 312 and the supporting plate 314, generally only the molding compound 116 exposes on the first surface 318 of the integral assembly 316.

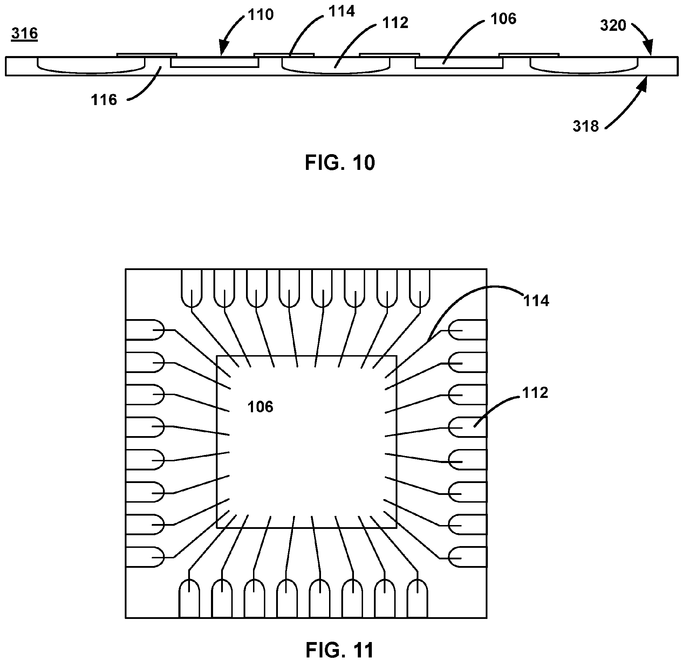

In step 214, the integral assembly 316 is flipped, such that the first surface 318 holds the integral assembly 316. Also in step 214, connection lines are applied for providing electrical connection between the device die and the perimeter landings. With reference to FIG. 10, each connection line 114 has a first end in contact with, and providing electrical connection to, a contact pad (not shown) on the second surface 110 of the device die 106, and a second end in contact with, and providing electrical connection to, one of the perimeter landings 112 which is corresponding to the contact pad of the device die 106. The connection line 114 is connected to the integral assembly 316 on the second surface 320, such that the resulting packaged semiconductor device can have as compact size as possible. The connection line 114 can be any one of various compact connection means, for example, copper clips with a flat shape. In the embodiment, the connection line 114 has a thickness of 10µm to 20µm. In some embodiments, the connection line 114 can be applied through 3D printing techniques, or so named "Jet Printing" technique, which dispenses functional fluid, for example conductive ink, in a trace, thereby forming conductive lines.

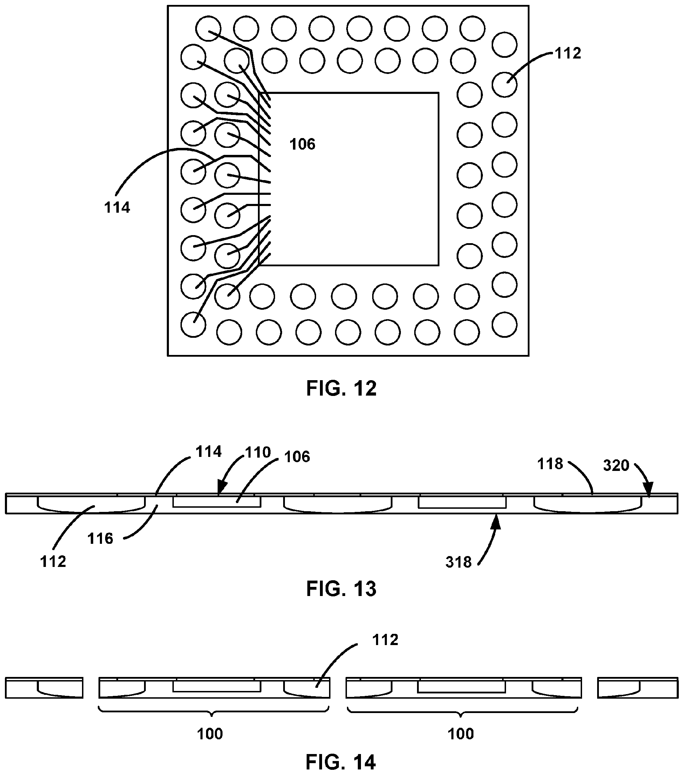

FIG. 11 shows a partial view of an example in which each semiconductor device has one row of perimeter landings 112 on each edge. The perimeter landings 112 generally has a semi-oval shape, corresponding to the aperture in the stencil, but with some rounding or smoothing resulting from the reflow process. In FIG. 11, each of the connection lines 114 are connected to a corresponding one of the perimeter landings 112 from the device die 106. FIG. 12, on the other hand, shows another example in which each semiconductor device has two rows of perimeter landings 112 on each edge. The perimeter landings 112 of FIG. 12 is configured as circular (which depends on the aperture of the stencil allowing the paste material to be printed in), and the connection lines 114 are also connected to the corresponding one of the perimeter landings 112 from the device die 106, while the connection lines 114 are routed to avoid contacting each other and avoiding contacting other perimeter landings 112.

In the method of FIG. 2, step 216 follows with coating, with a coating layer, the second surface on which the connection lines have been applied. Referring also to FIG. 13, the coating layer 118 is coated onto the second surface 320, to cover the second surface 320 and the connection lines 114. As described above, the coating layer 118 may be conformal coating of lacquer or other applicable paints, to protect the second surface 110 of the device die 106, the perimeter landings 112 that expose from the molding compound 116 on the second surface 320, and the connection lines 114 from humidity, acidity, or other rusts or corrosions. The coating layer 118 is disposed on the second surface 320 to a thickness which is typically equal to or larger than the thickness of the connection lines 114. In examples where the coating layer 118 is disposed through conformal coating, the disposed coating material flows over the connection lines 114. As described above, the thickness of the connection line may typically in a range of 10µm and 20µm. In the embodiment, the thickness of the coating layer 118 is in a range of 25µm and 40µm. Step 216 further includes, optionally, grinding the integral assembly 316 from the first surface 318. Grinding the assembly 316 thins it and ensures that the perimeter landings 112 on the first surface 318 are properly exposed, with no residual molding compound thereunder. As illustrated, the second surface 320 is coated and insulated, the perimeter landings 112 are exposed on the first surface 318 by back-grinding for providing external connection of the manufactured packaged semiconductor device 100.

Step 218 of the method of FIG. 2 separates each integral assembly in which a device die is embedded from each other. This can be implemented by laser scribing, saw blading, or etching along the predetermined scribe lines, saw channels, or dicing streets between neighboring integral assemblies. With reference to FIG. 8 and FIG. 14, in the array, each perimeter landing 112 may be part of a larger region which is shared by neighboring integral assemblies, and this step 218 divides the region comprising the pair of perimeter landings 112 by sawing or other applicable techniques, such that each packaged semiconductor device 100 includes a separate perimeter landing 112.

In the described embodiments, the packaged semiconductor device has the perimeter landings manufactured through stencil printing and reflowing, with no requirement for a convention lead-frame, bumping, etc. The manufactured semiconductor device can be very compact and thin, with a thickness typically of at the minimum 0.05mm to 0.1mm, which is thin, compared to conventional packaged semiconductor devices.

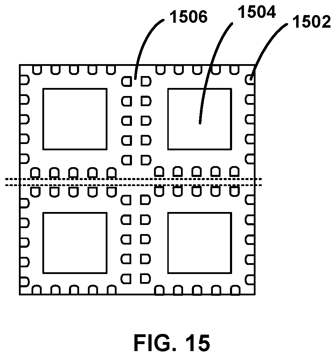

FIG. 15 is a partial plan view of a device die and surrounding perimeter landings during a manufacturing stage similar to that of FIG. 8. Stencil for printing the paste material for the perimeter landings 1502 is configured that the neighboring central areas for receiving the device dies 1504 do not share a common paste material region as that illustrated by 802 in FIG. 8. Instead, the perimeter landings 1502 on perimeter regions of one device die 1504 is apart from neighboring perimeter landings 1502 for neighboring device die 1504 by a gap 1506. The gap 1506 will be filled with the molding compound when the molding compound is applied. During the subsequent singulation process, the molding compound filled in the gap 1506 will be removed, as illustrated by the dotted line. The perimeter landings 1502 can either be exposed on the cut from the singulation if the singulation step is implemented wide enough to reach the edge of the corresponding perimeter landings, or otherwise not exposed on the cut from the singulation if the singulation does not reach the edge of the perimeter landings.

The use of the terms "a" and "an" and "the" and similar referents in the context of describing the subject matter (particularly in the context of the following claims) are to be construed to cover both the singular and the plural, unless otherwise indicated herein or clearly contradicted by context. The terms "coupled" and "connected" both mean that there is an electrical connection between the elements being coupled or connected, and neither implies that there are no intervening elements. In describing transistors and connections thereto, the terms gate, drain and source are used interchangeably with the terms "gate terminal", "drain terminal" and "source terminal". Recitation of ranges of values herein are intended merely to serve as a shorthand method of referring individually to each separate value falling within the range, unless otherwise indicated herein, and each separate value is incorporated into the specification as if it were individually recited herein. Furthermore, the foregoing description is for the purpose of illustration only, and not for the purpose of limitation, as the scope of protection sought is defined by the claims set forth hereinafter together with any equivalents thereof entitled to. The use of any and all examples, or exemplary language (e.g., "such as") provided herein, is intended merely to better illustrate the subject matter and does not pose a limitation on the scope of the subject matter unless otherwise claimed. The use of the term "based on" and other like phrases indicating a condition for bringing about a result, both in the claims and in the written description, is not intended to foreclose any other conditions that bring about that result. No language in the specification should be construed as indicating any non-claimed element as essential to the practice of the disclosure as claimed.

Preferred embodiments are described herein, including the best mode known to the inventor for carrying out the claimed subject matter. Of course, variations of those preferred embodiments will become apparent to those of ordinary skill in the art upon reading the foregoing description. The inventor expects skilled artisans to employ such variations as appropriate, and the inventor intends for the claimed subject matter to be practiced otherwise than as specifically described herein. Accordingly, this claimed subject matter includes all modifications and equivalents of the subject matter recited in the claims appended hereto as permitted by applicable law.

## Claims

1. A packaged semiconductor device having a top surface and a bottom surface opposite the top surface, the packaged semiconductor device comprising:
a device die having a first surface and a second surface opposite the first surface, wherein the device die is arranged in a central region of the packaged semiconductor device, and wherein the first surface of the device die is arranged towards the bottom surface of the packaged semiconductor device, and the second surface of the device die is arranged towards the top surface of the packaged semiconductor device;
a plurality of perimeter landings exposed on the bottom surface of the packaged semiconductor device and arranged at perimeter regions of the bottom surface surrounding the device die;
connection lines connected to the second surface of the device die, wherein each connection line provides electrical connection between a corresponding connection pad on the second surface of the device die and a corresponding one of the plurality of perimeter landings; and
molding compound at least partially encapsulating the device die and the plurality of perimeter landings;
wherein the plurality of perimeter landings are made of a material having a mass fraction of tin of at least 95%.

2. The packaged semiconductor device of claim 1, wherein a thickness of the connection line is in a range of 10µm and 20µm.

3. The packaged semiconductor device of claim 1 or 2, wherein an active area of the device die faces towards the second surface of the device die.

4. The packaged semiconductor device of any preceding claim, wherein the molding compound is exposed on the bottom surface of the packaged semiconductor device.

5. The packaged semiconductor device of any preceding claim, wherein the connection lines are arranged across the top surface of the molding compound.

6. The packaged semiconductor device of any preceding claim, wherein a melting temperature of the molding compound is lower than a eutectic temperature of the perimeter landings.

7. The packaged semiconductor device of any preceding claim 1, further comprising a coating layer disposed at the top surface of the packaged semiconductor device.

8. The packaged semiconductor device of claim 7, wherein a thickness of the coating layer, between the molding compound and the top surface of the packaged semiconductor device, is equal to or is larger than a thickness of the connection line.

9. The packaged semiconductor device of claim 7 or 8, wherein a thickness of the coating layer is in a range of 25µm and 40µm.

10. A method of manufacturing a packaged semiconductor device comprising:
providing a patterned paste material having a mass fraction of tin of at least 95% on a carrier;
reflowing the patterned paste material to form a plurality of arranged perimeter landings;
positioning a device die such that it is surrounded by the plurality of arranged perimeter landings;
filling molding compound to integrate the perimeter landings and the device die into an integral assembly having a first surface; and
forming a connection line, between a connection pad on a first surface of the device die on the first surface of the integral assembly, and a one of the plurality of arranged perimeter landings, to provide electrical connection therebetween.

11. The method of claim 10, wherein providing the patterned paste material on the carrier comprises printing the paste material through apertures of a stencil.

12. The method of claim 10 or 11, wherein providing the patterned pasts material on the carrier comprises printing the paste material on a first plate, and the method further comprising:
applying a tape on the patterned paste material before reflowing the patterned paste material, such that the plurality of arranged perimeter landings are sandwiched between the first plate and the tape after the reflowing; and
removing the first plate; and wherein
the positioning the device die comprises placing the device die on a first side of the tape, the plurality of arranged perimeter landings are arranged on the first side of the tape.

13. The method of claim 12, further comprising removing the tape after the filling the molding compound.

14. The method of claim 12 or 13, further comprising:
applying a second plate on a second side of the tape opposite the first side; and
removing the tape and the second plate after the filling molding compound.

15. The method of any of claims 12 to 14, wherein the first plate is a ceramic plate, the tape is a high-temperate tape; and the second plate is a rigid supporting plate.
